(19) Europäisches Patentamt
European Patent Office
Office européen des brevets

(11) **EP 1 667 055 A1**

(12) **EUROPEAN PATENT APPLICATION**
published in accordance with Art. 158(3) EPC

(43) Date of publication:
07.06.2006 Bulletin 2006/23

(51) Int Cl.:
*G06K 19/00* (1968.09)    *G11B 7/0065* (2000.01)
*G03H 1/26* (1974.07)

(21) Application number: 04773383.7

(22) Date of filing: 16.09.2004

(86) International application number:
**PCT/JP2004/013999**

(87) International publication number:
**WO 2005/029399 (31.03.2005 Gazette 2005/13)**

(84) Designated Contracting States:
**DE FR GB**

(30) Priority: 18.09.2003  JP 2003325995
26.04.2004  JP 2004129871

(71) Applicant: **NIPPON TELEGRAPH AND TELEPHONE CORPORATION**
**Tokyo 100-8116 (JP)**

(72) Inventors:
• **Dobashi, Hisanobu,**
**NTT Intellectual Prop. Center**
**Musashino-shi, Tokyo 180-8585 (JP)**
• **Furuya, Akinori,**
**NTT Intellectual Prop. Center**
**Musashino-shi, Tokyo 180-8585 (JP)**
• **Senda, Masakatsu,**
**NTT Intellectual Prop. Center**
**Musashino-shi, Tokyo 180-8585 (JP)**
• **Yoshikawa, Hiroshi,**
**NTT Intellectual Prop. Center**
**Musashino-shi, Tokyo 180-8585 (JP)**
• **Yagi, Shogo,**
**NTT Intellectual Prop. Center**
**Musashino-shi, Tokyo 180-8585 (JP)**
• **Sakamoto, Hideki,**
**NTT Intellectual Prop. Center**
**Musashino-shi, Tokyo 180-8585 (JP)**

(74) Representative: **Poulin, Gérard**
**BREVALEX**
**3, rue du Docteur Lancereaux**
**75008 Paris (FR)**

(54) **OPTICAL MEMORY MEDIUM AND OPTICAL MEMORY MEDIUM REPRODUCING DEVICE**

(57)    An optical memory medium includes at least one multi-layered waveguide hologram ROM (2-7) that uses diffracted light based on incident light to a multi-layered waveguide hologram to read out data, and at least one memory (2-5) that is integrally constituted with the multi-layered waveguide hologram ROM and is used to read and write data. A reproduction apparatus for the optical memory medium includes a light inputting unit (4-3, 4-4) for inputting light into the multi-layered waveguide hologram of the optical memory medium, a light receiving element (4-9) for receiving light diffracted by the multi-layered waveguide hologram from the light input by the light inputting unit and for converting into an electric signal, and a data record reproduction unit (4-6, 4-7) for reading and writing data with respect to the memory of the optical memory medium.

FIG. 1

EP 1 667 055 A1

## Description

PRIORITY CLAIM

Priority is claimed on Japanese Patent Application Nos. 2003-325995, filed September 18, 2003, and 2004-129871, filed April 26, 2004, the content of which is incorporated herein by reference.

TECHNICAL FIELD

The present invention relates to an optical memory medium and a reproduction apparatus therefor containing a holographic ROM in which contents are stored and a memory having the ability to rewrite data.

BACKGROUND ART

In a technique called waveguide holography, minute concavities and convexities are formed in a single mode planar waveguide, guided wave light by the minute concavities and convexities is diffracted, and an arbitrary wave front is taken out of the waveguide. A collection of minute concavities and convexities in the waveguide plane formed in order to establish a desired wave front is called a waveguide hologram. The holography can be classified as volume holography and thin film holography. The waveguide holography is a kind of thin film holography. A multi-layered waveguide hologram is obtained by laminating a waveguide in which a waveguide hologram is manufactured. Since the multi-layered waveguide hologram, which is thin film hologram, can use a three dimensional region as a recording area, the multi-layered waveguide hologram can be applied as a large capacity of optical memory. For example, see Japanese Unexamined Patent Publication Hei 11-345419.

However, at present, as far as the multi-layered waveguide holography is used, there was a disadvantage that usage is limited, because only a memory exclusive for reproduction can be actually used which does not allow a user to record depending on a situation. In order to overcome the disadvantage, there has been a proposal that IC chips should be manufactured together. For example, see Japanese Unexamined Patent Publication 2003-141475. However, this has not been realized.

On the other hand, semiconductor memories such as a freely rewritable flash memory are expensive. Consequently, the semiconductor memories are mainly used as a temporary storage in which the semiconductor memories themselves do not have to be replaced, and are not appropriate for the distribution of a large amount of information or the use for archive.

Considering the above situation, there is a need for an optical memory medium and a reproduction apparatus thereof, by which a large capacity of common data can be inexpensively recorded for exclusive use of rewriting, and information a user wishes to rewrite can be freely recorded or reproduced.

DISCLOSURE OF INVENTION

The present invention is directed to an optical memory medium and a reproducing apparatus thereof that satisfy the need.

One aspect of the invention relates to an optical memory medium. The optical memory medium comprises at least one multi-layered waveguide hologram ROM for storing data to be read out by using diffracted light based on incident light to a multi-layered waveguide hologram to read out data; and at least one memory integrally constituted with the multi-layered waveguide hologram ROM for reading and writing data.

Preferably, the optical memory medium further comprises a guide for fixing the multi-layered waveguide hologram ROM so that the multi-layered waveguide hologram ROM is removable.

Preferably, in the optical memory medium the memory for reading and writing is an IC memory, and the optical memory medium further comprises a plurality of terminals for the IC memory placed in a predetermined circumferential portion of the optical memory medium; and an incident portion of reference light for the multi-layered waveguide hologram ROM placed in another circumferential portion adjacent to the predetermined circumferential portion for the terminals for the IC memory.

Preferably, in the optical memory medium, the optical memory medium has external dimensions of 32 mm x 24 mm x 2.1 mm, or has all or any of the external dimensions less than 32 mm x 24 mm x 2.1 mm.

The second aspect of the invention is directed to a reproduction apparatus for an optical memory medium. The reproduction apparatus for an optical memory medium comprises an optical memory medium which includes at least one multi-layered waveguide hologram ROM for storing data to be read out by using diffracted light based on incident light to a multi-layered waveguide hologram; and at least one memory integrally constituted with the multi-layered waveguide hologram ROM for reading and writing data. The reproduction apparatus further comprises a light inputting unit for inputting light into the multi-layered waveguide hologram; a light receiving unit for receiving light diffracted at the multi-layered waveguide hologram based on the light input by the light inputting unit to convert into an electric signal; and a data record reproducing unit for reading and writing data with regard to the memory.

Preferably, the reproduction apparatus for an optical memory medium further comprises a determination unit for determining whether or not a medium being inserted is the optical memory medium, depending on whether or not the diffracted light emitted from the multi-layered waveguide hologram ROM is detected by the light receiving unit.

BRIEF DESCRIPTION OF THE DRAWINGS

Figure 1 is a perspective view for illustrating the structure of an optical memory medium of a first embodiment in accordance with the invention.

Figure 2 is a sectional view of one example of the structure of a multi-layered waveguide hologram ROM.

Figure 3 is a sectional view of another example of the structure of a multi-layered waveguide hologram ROM.

Figure 4 is a perspective view for illustrating the structure of an optical memory medium of a second embodiment in accordance with the invention.

Figures 5A and 5B are a perspective view for illustrating the structure of an optical memory medium of a third embodiment in accordance with the invention.

Figure 6 is a perspective view for illustrating the structure of a reproduction apparatus for an optical memory medium of a fourth embodiment in accordance with the invention.

Figure 7 is a perspective view for illustrating the structure of a reproduction apparatus for an optical memory medium of a fifth embodiment in accordance with the invention.

Figures 8A to 8C are a perspective view for illustrating the structure of a reproduction apparatus for an optical memory medium of a sixth embodiment in accordance with the invention, respectively.

BEST MODE FOR CARRYING OUT THE INVENTION

Referring to the figures, the embodiments of the invention will be described below.

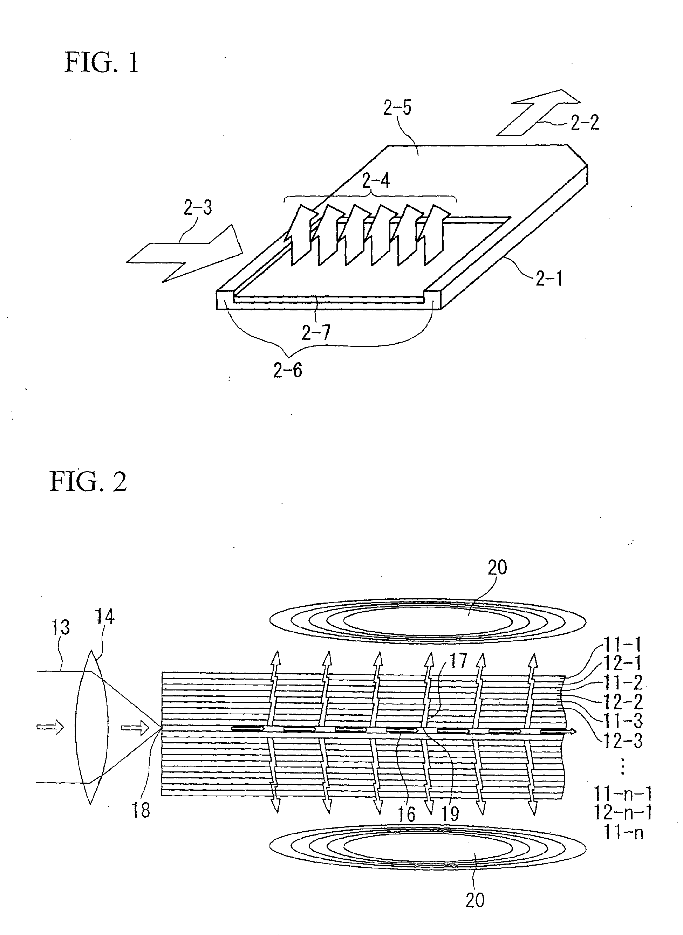

Figure 1 is a perspective view for illustrating the structure of an optical memory medium of a first embodiment in accordance with the invention. In this figure, 2-1 is an optical memory medium having dimensions of 32 mm x 24 mm x 2.1 mm, constituting a pentagon with one corner cut off. The cutting off determines a direction 2-2 for inserting the optical memory medium. With reference to the medium inserting direction 2-2, the optical memory medium includes an IC (flash) memory 2-5 at the front and a multi-layered waveguide hologram ROM 2-7 at the back. (A hologram ROM is also called a "holographic ROM.") The hologram ROM 2-7 can be replaced and fixed by a guide 2-6.

In the optical memory medium 2-1, connecting terminals connected with the IC memory in the IC memory portion 2-5 is placed on an end or an undersurface of the side of the medium insertion direction 2-2 so that the optical memory medium 2-1 can touch electrode terminals of a reproduction apparatus of the optical memory medium to be inserted. On the side where the connecting terminals of the IC memory is provided and the adjacent side, a light incident portion of the hologram ROM 2-7 is provided.

The light to reproduce information stored in the hologram ROM 2-7 enters from the 2-3 direction, when, as shown in Figure 1, the light incident portion is placed on a left side with reference to the medium insertion direction 2-2. On this occasion, on the side where the light incident portion is placed, an optically transparent member or a hole is provided in order to pass the light. The light incident on the light incident portion propagates along the waveguide in the hologram ROM 2-7 to be diffracted in a hologram pattern provided in the waveguide.

Under the circumstances, the light traveling the waveguide is diffracted on the upper side and on the lower side in the direction vertical to the 32 mm x 24 mm surface. On the surface tangent to a surface opposite to a surface on the side where the diffracted light of the hologram ROM 2-7 of the light memory medium itself is taken out, a light absorber is provided. The light diffracted in this direction is converted to heat. Because of that, as a result, only the light diffracted in the 2-4 direction in the direction vertical to the 32 mm x 24 mm surface is extracted as a signal light, and is focused as a reproduced image on a two-dimensional light-receiving element placed in the reproducing apparatus for the light memory medium.

Moreover, the following may be used. By providing a light absorbent in the light memory medium, instead of absorbing the light diffracted in the direction opposite to the 2-4 direction, the surface tangent to the hologram ROM 2-7 of the light memory medium and the lower portion thereof are made transparent. While the diffracted light is transmitted to an outer portion of the light memory medium, by providing a light absorbent in the generating apparatus for the light memory medium, the light diffracted in the direction opposite to the 2-4 direction can be absorbed.

On each guide 2-6, a groove wider a little than the thickness of the hologram ROM 2-7 is provided on a portion tangent to the inner side (the side of the hologram ROM 2-7) of the hologram ROM 2-7. The hologram ROM is inserted along the grooves in the direction identical to the medium insertion direction 2-2 to be mounted. The number of the grooves, each of which is provided on the inner side of the left and right guides 2-6, respectively, is two with regard to one hologram ROM 2-7 to be inserted.

When mounting the hologram ROM 2-7 in the light memory medium 2-1, the length of the groove of the guide 2-6 should be set to be identical to that of the insertion direction or a little longer. Then, an initial incident position of laser beam in the reproduction apparatus for the optical memory medium may be set to agree to the position of the light incident portion of the hologram ROM 2-7. In the state set in this way, there may occur a slight positional difference between the initial incident position of the laser beam in the reproduction apparatus and the position of the light incident portion of the hologram ROM 2-7. In that case, an actuator for shifting the incident position of the laser beam may be provided in the reproduction apparatus to adjust the incident position of the laser beam.

Moreover, the following can be adopted. A dent may be provided on the surface in contact with the groove of the guide 2-6 of the hologram ROM 2-7, and a convex portion may also be provided where a spring is set in the groove of the guide 2-6. When the convex portion fits into the dent of the hologram ROM 2-7, the hologram ROM 2-7 can be fixed at the most appropriate position for the incidence of the laser beam.

Only one set of grooves of the guide 2-6 should be provided, when the number of the hologram ROM 2-7 to be inserted into the body of the optical memory medium 2-1 is one. On the other hand, where a plurality of hologram ROMs are to be inserted into the body of the optical memory medium 2-1, for example, where a plurality of hologram ROMs having the same area are to be inserted so that the hologram ROMs can be overlapped in the thickness direction, the number of the set of grooves of the guide 2-6 should be the same as that of the hologram ROMs to be inserted.

Figure 2 is a drawing for illustrating one example of the structure of a multi-layered waveguide hologram ROM and an arrangement of input and output of the light beam. As shown in Figure 2, the hologram ROM is a periodical layer structure composed of "cladding 11-1/ core 12-1/ cladding 11-2/ core 12-2/.../ cladding 11-n". Any of "cladding / core / cladding" unit is a plane single mode waveguide with respect to the wavelength of a laser beam 13 to be used. The planar waveguide is a so-called slab optical waveguide, containing as a core layer a plane transparent medium such as quartz or plastic which is sandwiched by a medium having a lower index of refraction. The planar waveguide allows the light beam to propagate in the in-plane direction, confining the light beam in the core layer, and can be applied to optical communication components. The hologram ROM is multi-layered piling this type of planar waveguide, and each of the guided wave layers includes hologram.

Reference numeral 14 is a convex lens, but can be a cylindrical lens. An end face of the planar waveguide stacked by the hologram ROM is vertical with respect to the waveguide plane. The laser beam 13 is incident on the hologram ROM from the lateral direction parallel to the waveguide plane via the convex lens 14. The laser beam 13 input is focused on a predetermined core layer 18, by adjusting a position of the convex lens 14.

In addition, in order to propagate the laser beam 13, a numerical aperture (NA) of the convex lens 14 should be smaller than that of the waveguide. When the NA is made smaller, a focusing spot of the lens will be larger. In the case of a single mode waveguide, when light beam is to be coupled directly to the waveguide from in the air, the spot size always exceeds the width of the waveguide to fail to make coupling efficiency 100 %.

The NA ($NA_L$) of the lens is defined by:

$$NA_L = D / \sqrt{f^2 + D^2}$$

where 2D is a diameter of the lens, and f is a focal length. On the other hand, the NA ($NA_{WG}$) of the waveguide is defined by:

$$NA_{WG} = \sqrt{na^2 - nc^2}$$

where an index of refraction of the core layer is expressed by na, and an index of refraction of the cladding layer is shown as nc.

As shown in Figure 2, the light beam introduced into the waveguide from the incident point (coupling point of the guided wave light) 18 becomes guided light beam 16 to travel mainly along the core layer in the waveguide, expanding in the shape of a fan with the incident point 18 pivoted. The expanding angle is expressed by 2 sin$^{-1}$ ($NA_L$), which can be altered by selecting a convex lens. When a cylindrical lens is used as the lens 14, the light beam becomes guided light beam that travels with a constant width, not expanding in the shape of a fan.

The guided light 16 is partially scattered by a scattering factor (hologram) 19 provided in the core layer or the cladding layer to leak the waveguide. When the scattering factor has a periodic structure, there is a direction in which a phase of the scattered light beam from each scattering factor agrees. Since the guided light 16 turns into diffracted light beam 17 that travels to that direction, the diffracted light beam 17 travels also out of the waveguide to form a hologram image 20. The hologram image 20 is detected by a two-dimensional detector such as a charge coupled device (CCD) to be read out for the information therein.

An explanation is given of this embodiment in which a two-dimensional detector as a light receiving element is used. However, the invention is not limited to this case. That is, a line sensor, which is a one-dimensional light receiving element, or a photo detector, which is a light receiving element for detecting the intensity of light at specified one spot can be scanned one-dimensionally or two-dimensionally when used.

In addition, by moving the convex lens 14 in Figure 2, the guided wave layer for propagating the light beam can be changed, which enables information recorded in each of the layers to be read out separately.

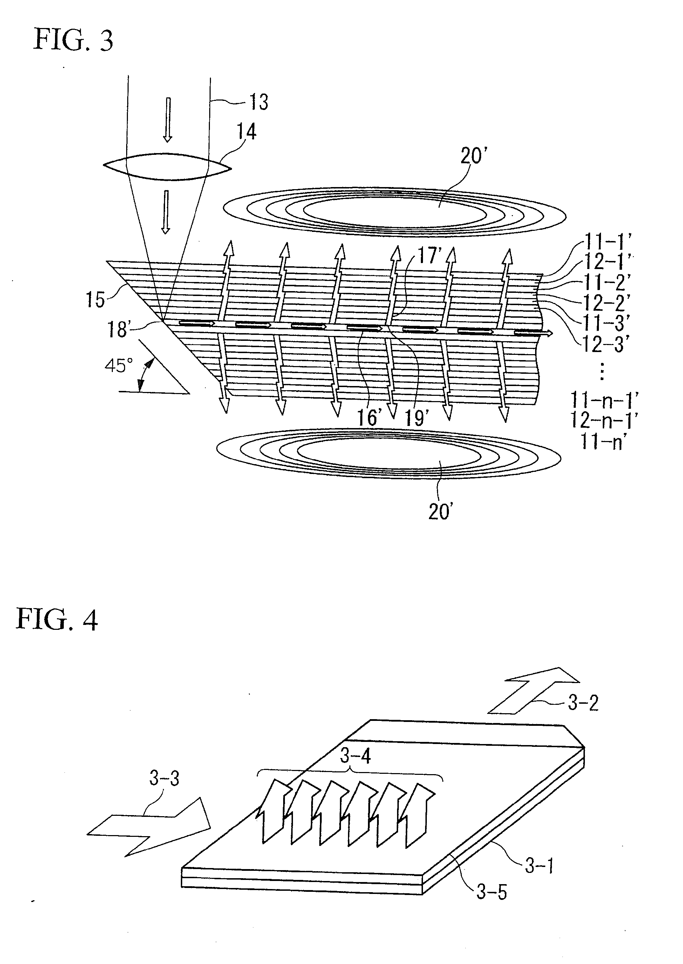

Figure 3 is a drawing for illustrating another example of the structure of the multi-layered waveguide hologram ROM and a method of inputting and outputting the light beam. In this example, at least one portion of the end of the planar waveguide plied is a reflective surface 15 having 45 degrees with respect to the vertical direction (normal direction) to the waveguide plane. The hologram ROM of Figure 3 is different from that of Figure 2 in this point, but is the same as that of Figure 2 in other points. The hologram ROM of Figure 3 contains a periodical structure "cladding 11-1' / core 12-1' / cladding 11-2' / core 12-2' / ... / cladding 11-n'".

The position of the convex lens 14 is adjusted so that the reproduction laser beam 13 can be focused at a core layer portion 18'cut at angle of 45 degrees of a predetermined waveguide. When the reflective surface 15 is exposed, total reflection occurs. It is not necessary to provide a special reflective layer with the reflective surface. However, where resin is used for protection to enhance durability, it is necessary to form a dielectric film or metallic film as a reflective layer.

The light beam introduced into the waveguide through a reflective point 18' becomes guided wave light 16' to travel mainly into the core layer in the waveguide, expanding in a shape of a fan. As the movement of the guided wave light 16' afterwards is the same as that of Figure 2, a brief explanation will be given hereinbelow. The guided wave light 16' is partially scattered by the scattering factor (hologram) 19' to leak from the waveguide. Since the guided wave light 16' travels as diffracted light 17' in the direction where the phase of the scattered light from each of the scattering factors 19' agrees, the light propagates even outside of the waveguides to form a hologram image 20'.

Figure 4 is a perspective view for illustrating the structure of an optical memory medium of a second embodiment in accordance with the invention. The optical memory medium, which has an outer dimension of 32 mm x 24 mm x 2.1 mm, includes an IC (flash) memory at a lower portion 3-1, and a hologram ROM at an upper portion 3-5, with the IC memory and the hologram ROM stuck together. The direction of inserting the medium is 3-2.

The optical memory medium has a connection terminal connected to the IC memory in the IC memory portion 3-1. The connection terminal is placed on the end of the side, or on the undersurface, of the medium insertion direction 3-2 of the optical memory medium so that the optical memory medium can touch the electrode terminal of the reproduction apparatus for the optical memory medium to be inserted.

A light incident portion of the hologram ROM 3-5 is placed on a side adjacent to a side where the connection terminal of the IC memory is placed. The light beam for reproducing information recorded in the hologram ROM 3-5, as shown in Figure 4, enters from the 3-3 direction with respect to the light incident portion, when the light incident portion is placed on the left side with respect to the medium insertion direction 3-2. The light beam incident on the light incident portion travels along the waveguide in the hologram ROM 3-5 to be diffracted by the hologram patterns provided in the waveguide.

Under the circumstances, the light beam that propagates into the waveguide is diffracted in both the upper and lower directions vertical to the surface 32 mm x 24 mm. A light absorbent is provided on the surface tangent to the opposite surface with respect to the surface from which the diffracted light of the hologram ROM 3-5 of the IC memory portion 3-1 is taken out. The light diffracted in this direction is converted into the heat. Because of this, as a result, only the light diffracted in the 3-4 direction vertical to the surface 32 mm x 24 mm is extracted as a signal light, which is focused as a reproduced image on the two-dimensional light receiving element placed in the reproduction apparatus for the optical memory medium.

The present embodiment is realized by an example in which the IC memory portion 3-1 and the hologram ROM 3-5 are stuck together in a fixed manner. However, the following structure can be employed. As in the first embodiment, guides are provided on both left and right sides or on both front and back sides of the medium insertion direction 3-2, so that the hologram ROM 3-5 can be removable.

The present embodiment can use the two-dimensional photo detector as a light receiving element, but is not limited to this. The line sensor, which is one-dimensional light receiving element, can be used, or the photo detector, which is a light receiving element for detecting light at a specified one point, can also be used by scanning one dimensionally or two dimensionally.

In addition, when the multi-layered waveguide hologram ROM 3-5 and the memory 3-1 are stuck together, order does not have to be specified so long as the memory 3-1 does not block the signal light (diffracted light) emitting from the multi-layered waveguide hologram ROM 3-5.

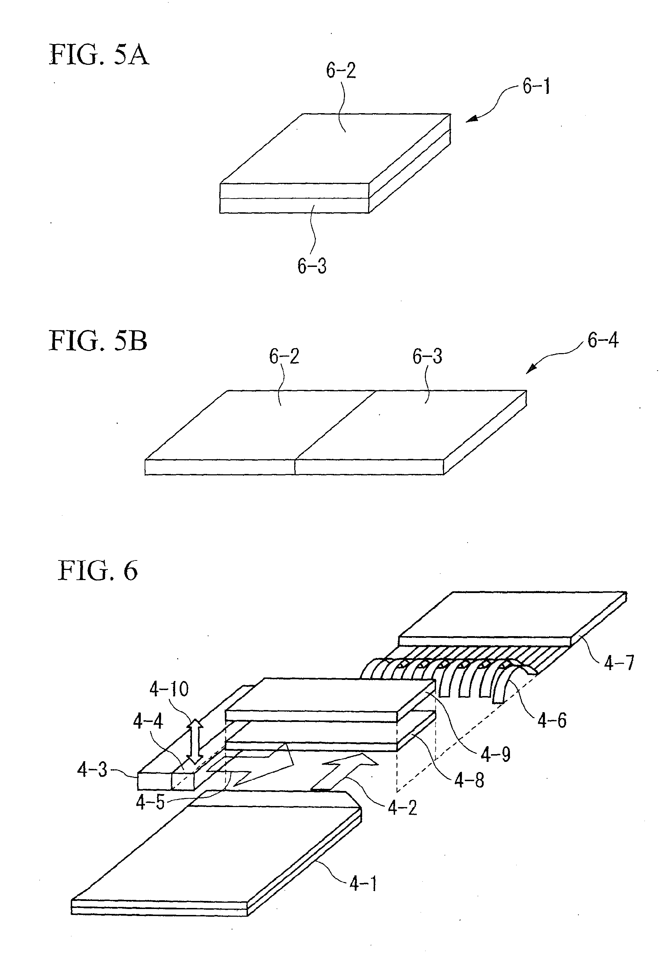

Figures 5A and 5B are a perspective view for illustrating the structure of the optical memory medium of a third embodiment in accordance with the invention. Figure 5A is an outline for showing an optical memory medium 6-1 which includes a plate multi-layered waveguide hologram ROM 6-2 and a plate memory 6-3, with the hologram ROM 6-2 and the memory 6-3 stacked up in two layers in the vertical direction (that is, in the thickness direction).

The following can be used as the memory 6-3: a flash memory (for example, SD (Secure Digital) memory card, and memory stick), a HDD (Hard Disk Drive) (for example, microdrive), a MT (Magnetic Tape) (for example, magnetic stripe, and magnetic tape), a contact type/noncontact type IC chip, an IC tag, an optical disc (for example, CD, DVD, AOD (Advanced Optical Disk), BD (Blu-ray Disk), and ROM, R, and RW of MO system), and a recording type hologram memory.

The data stored in the memory 6-3 can be format information characteristic to the multi-layered waveguide hologram ROM 6-2, ID (Identification), encryption key, information with a time limit, or store information on a map. For example, the following structure can be used. The multi-layered waveguide hologram ROM 6-2, which is used only for readout, records base map data having slow time variation, while the memory 6-3 uses a readable and writable RAM to record store information on a map having fast time variation. According to the structure, since only data that needs updating may be recorded in the memory 6-3, it is easier for a user to manage.

The present embodiment relates to the case in which the multi-layered waveguide hologram ROM 6-2 and the memory 6-3 are stacked in two layers in the vertical direction. However, the present embodiment is not limited to the two layers, and can be realized using three or more layers. Order for piling up the multi-layered waveguide hologram ROM 6-2 and the memory 6-3 is not limited to the one shown in Figure 5A.

That is, it is possible to locate the memory 6-3 on the multi-layered waveguide hologram ROM 6-2. Even where the memory 6-3 and the multi-layered waveguide hologram ROM 6-2 are stacked over three stages, the order is not limited to a specified one. So long as the memory 6-3 does not block signal light (diffracted light) emitted from the multi-layered waveguide hologram ROM 6-2, the multi-layered waveguide hologram ROM 6-2 and the memory 6-3 can be stacked in a variety of orders.

Figure 5A shows one case showing the structure in which the multi-layered waveguide hologram ROM 6-2 and the memory 6-3 are stacked in the two stages in the vertical direction to constitute the optical memory medium 6-1. The structure of Figure 5B can also be employed. That is to say, the multi-layered waveguide hologram ROM 6-2 and the memory 6-3 can be integrally placed in the lateral direction (namely, in the width direction or depth direction) in the shape of a plate, respectively, to constitute the optical memory medium 6-4. Except for the structures of the optical memory medium shown in Figures 5A and 5B, the multi-layered waveguide hologram ROM 6-2 and the memory 6-3 can be also made integral by combining each of the heights, sides, insides, or outsides of the multi-layered waveguide hologram ROM 6-2 and the memory 6-3.

Figure 6 shows the structure of the reproduction apparatus for the optical memory medium of a fourth embodiment in accordance with the invention.

An optical memory medium 4-1 illustrates an example of the medium shown in Figure 4. The optical memory medium 4-1 is inserted into the direction of 4-2. Under the medium 4-1, there is an IC (flash) memory that contains electrode terminals 4-6 and a processing circuit 4-7 for transferring the data of the IC memory.

When the optical memory medium 4-1 is inserted into the reproduction apparatus for the optical memory medium, connection terminals connected to the IC memory of the optical memory medium 4-1 contacts with the electrode terminals 4-6 of the reproduction apparatus for the optical memory medium, so that data transfer between the processing circuit 4-7 and the IC memory can be made possible. Towards the optical memory medium 4-1 inserted in this way, a laser beam is input from the direction of 4-5 to reproduce the information recorded in the hologram ROM.

The laser beam is focused through a Fresnel cylindrical lens 4-4. In order to select a layer through which the hologram ROM is reproduced, an actuator 4-3 controls the cylindrical lens 4-4 upward and downward (in the direction of 4-10). The guided wave light that travels along the selected wave guide layer is diffracted by the hologram. The diffracted light reaches a CCD 4-9 by way of a liquid matrix shutter 4-8 and is focused as a two-dimensional image. The liquid matrix shutter 4-8 is not essential and need not be used.

In addition, the present embodiment can use the two-dimensional light detector as a light receiving element, but is not limited to the two-dimensional light detector. The present embodiment can also use a line sensor, which is a one-dimensional light receiving element, and a photo detector, which detects light at a specified one point, by scanning the line sensor and the photo detector one-dimensionally or two-dimensionally.

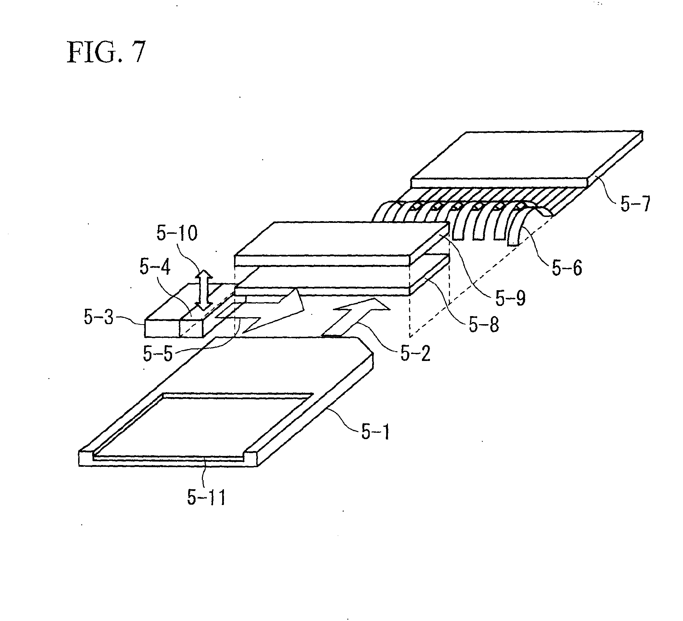

Figure 7 shows the structure of a reproduction apparatus for an optical memory medium of a fifth embodiment in accordance with the invention.

An optical memory medium 5-1 is one example of the medium shown in Figure 1. The optical memory medium 5-1 should be inserted in the direction of 5-2. The optical memory medium 5-1 includes an IC (flash) memory in the front portion thereof. In order to transfer data to and from the IC memory, the reproduction apparatus for the optical memory medium includes electrode terminals 5-6 and a processing circuit 5-7.

When the optical memory medium 5-1 is inserted into the reproduction apparatus for the optical memory medium, the connecting terminals connected to the IC memory of the optical memory medium 5-1 come into contact with the electrode terminals 5-6 of the reproduction apparatus for the optical memory medium, which allows data transfer between the processing circuit 5-7 and the IC memory. Toward the optical memory medium 5-1 inserted in this way, the laser beam is input from the direction of 5-5 so that the information stored in the hologram ROM can be reproduced.

The laser beam is focused via a Fresnel cylindrical lens 5-4. In order to select a layer through which the hologram ROM can be reproduced, an actuator 5-3 controls the cylindrical lens 5-4 upward and downward 5-10. The cylindrical lens 5-4 and the actuator 5-3 can be shorter than those (4-3 and 4-4) shown in Figure 5. The guided wave light that travels along the selected wave guide layer is diffracted by the hologram. The diffracted light reaches a CCD 5-9 by way of a liquid matrix shutter 5-8 and is focused as a two-dimensional image. The liquid matrix shutter 5-8 is not essential and need not be used.

In addition, the present embodiment can use the two-dimensional light detector as a light receiving element, but is not limited to the two-dimensional light detector. The present embodiment can also use a line sensor, which is a one-dimensional light receiving element, and a photo detector, which detects light at a specified one point, by scanning the line sensor and the photo detector one-dimensionally or two-dimensionally.

The fourth embodiment and the fifth embodiment can be applied to currently using IC memory cards. In this case, the detection of presence or absence of signal light by a two-dimensional light receiving element (CCD 4-9 and 5-9) determines whether or not the medium inserted and mounted in a slot is an optical memory medium shown in Figure 1 or Figure 4, or an IC memory card that is not an optical memory medium.

The processing procedure for this determination is shown below.

Step 1: When an optical memory medium shown in Figure 1 or Figure 4 is inserted into a slot, the connecting terminals of the optical memory medium come in contact with the electrode terminals 4-6 or 5-6, which allows data transfer between the processing circuit 4-7 or 5-7 and the IC memory. Because of this, a determination circuit provided in the processing circuit 4-7 or 5-7 detects the insertion of the optical memory medium or the IC memory having the same shape as the optical memory medium.

Step 2: The determination circuit allows the laser beam to illuminate at a predetermined position, in which the light incident portion of the optical memory medium is supposed to exist, from the incident optical system 4-4 or 5-4. Under this situation, when the hologram ROM exists, according to the same manner as the laser beam is input in the layer where the hologram information is stored, the actuator 4-3 or 5-3 can be controlled.

Step 3: When the hologram ROM exists, the illuminated laser light beam enters the layer in which hologram information of the hologram ROM is stored. The light beam propagates the layer, and is diffracted by the hologram provided in the layer. The two-dimensional light receiving element 4-9 or 5-9 detects the diffracted light from the hologram. On the other hand, when the hologram ROM does not exist, since the light beam is not diffracted, the two-dimensional light receiving element 4-9 or 5-9 does not detect the diffracted light. The determination circuit monitors whether or not the two-dimensional light receiving element 4-9 or 5-9 has detected the diffracted light.

Step 4: When the two-dimensional light receiving element 4-9 or 5-9 has detected the diffracted light, the determination circuit determines that a thing inserted is an optical memory medium to proceed to Step 5. In the meantime, when the two-dimensional light receiving element 4-9 or 5-9 does not detect the diffracted light, the determination circuit determines that something inserted is an IC memory card that has the same shape as that of the optical memory medium to proceed to Step 6.

Step 5: Where the processing circuit includes a main control circuit that controls communications with an external apparatus such as a PC connected to the reproduction apparatus for the optical memory medium and other processing, the determination circuit sends out to the main control circuit the information that the hologram ROM and the IC memory have been mounted. Furthermore, in response to the question as to what kind of card has been inserted from the external apparatus, the main control circuit answers that the hologram ROM and the IC memory have been mounted, and following the instructions from the external apparatus, reads out the data from the hologram ROM to execute read-out and write-in of the data with respect to the IC memory.

Step 6: The determination circuit transmits to the main control circuit the information that only the IC memory has been mounted, and stops driving the laser and the actuator 4-3 or 5-3. Moreover, in response to the question as to what kind of card has been inserted from the external apparatus, the main control circuit replies that only the. IC memory has been mounted, and following the instructions from the external apparatus, execute read-out and write-in of the data with respect to the IC memory.

In Step 1, when detecting that the optical memory medium or the IC memory card having the same shape as that of the optical memory medium is inserted, instead of a method of detecting by data transfer between the processing circuit 4-7 or 5-7 and the IC memory, a sensor may be provided that detects the insertion of the optical memory medium or the IC memory card having the same shape as that of the optical memory medium. Then, an output of the sensor may be used for the detection.

In Step 3, when monitoring that the two-dimensional light receiving element 4-9 or 5-9 has detected the diffracted light, it is possible to monitor that at least one portion of the two-dimensional light receiving element has detected the light beam, or that a specified one portion of the two-dimensional light receiving element has detected the light beam. However, in a case in which monitoring that a specified one portion of the two-dimensional light receiving element has detected the light beam, the hologram ROM should be structured so that at least one portion of a reproducing image can be focused without fail on the specified area of the two-dimensional light receiving element.

When the optical memory medium or the IC memory card is inserted into the reproduction apparatus for the optical memory medium, the determination circuit should be constituted so that the determination circuit may ordinarily once determine that the thing inserted is the optical memory medium or the IC memory card. However, in a case in which the hologram ROM can be removable, with the optical memory medium being inserted into the reproduction apparatus for the optical memory medium, it is desirable that the determination circuit be structured so that the determination circuit can periodically determine whether or not the hologram ROM is inserted, even if the optical memory medium remains inserted into the reproduction apparatus for the optical memory medium. In this case, after executing Step 1 only once, the procedures from Step 2 to Step 6 should be repeated at a predetermined interval.

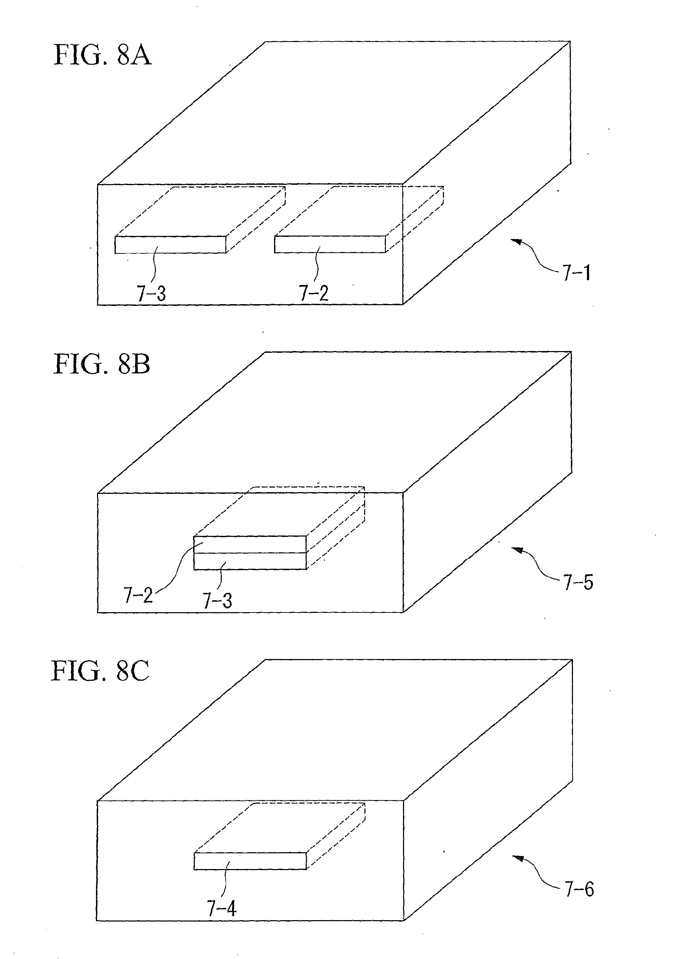

Figures 8A to 8C are each a perspective view for illustrating a location of a drive in a reproduction apparatus for an optical memory medium of a sixth embodiment in accordance with the invention. Figure 8A shows a drive 7-2 for reading out a multi-layered waveguide hologram ROM of a reproduction apparatus 7-1 for an optical memory medium, and a drive 7-3 for reading and writing a memory. The drive 7-2 and the drive 7-3 are independently placed. Under the situation, the reproduction apparatus 7-1 for the optical memory medium includes a slot for inserting the multi-layered waveguide hologram ROM and a slot for inserting the memory. Both of the slots exist independently in a front surface of the reproduction apparatus 7-1 for the optical memory medium.

The reproduction apparatus 7-1 for the optical memory medium can be composed of mobile devices such as a portable telephone, a game machine, a music recorder/player, a television set, an electronic dictionary, a pachinko-slot, a car navigation system, an electric book, a PDA (personal digital assistance), a teaching-material recorder/player, a note personal computer, a personal computer, and a server.

Figure 8B shows a drive 7-2 for reading out a multi-layered waveguide hologram ROM of a reproduction apparatus 7-5 for an optical memory medium, and a drive 7-3 for reading and writing a.memory. Both of the drives are stacked vertically.

In this case, the reproduction apparatus 7-5 for the optical memory medium includes a slot for inserting the multi-layered waveguide hologram ROM and a slot for inserting the memory. Both of the slots exist independently in a front surface of the reproduction apparatus 7-5 for the optical memory medium. However, the two slots can be seen as one slot from outer appearance, which can enhance user's convenience when compared with a case in which there are two slots.

In Figure 8B, the drive 7-2 for reading out the multi-layered waveguide hologram ROM is placed on the upper side, and the drive 7-3 for reading and writing the memory 7-3 is placed on the lower side. However, the embodiment is not limited to this structure, and can have another structure in which the order of the two drive is inverted.

Figure 8C shows a reproduction apparatus 7-6 for an optical memory medium in which one drive 7-4 is shared by read-out of a multi-layered waveguide hologram ROM and read and write of a memory. In this case, since the reproduction apparatus 7-6 for an optical memory medium has only one slot that shares the function for inserting the multi-layered waveguide hologram ROM and the function for inserting the memory.

After the reproduction apparatus 7-6 for an optical memory medium determines which one of the two drives should be used in response to the medium inserted into the slot, one of the two drives is selected in response to the medium inserted to be used for processing such as read-out of data.

The structure shown in Figure 8C does not require a user to determine which drive a medium should be inserted into. Accordingly, convenience for the user can be further enhanced.

As mentioned above, the present invention is described based on the embodiments. The first embodiment and the second embodiment are characterized by the fact that the optical memory medium can be inserted into a slot for the existing IC memory card such as a current SD card. It is natural that even if the hologram ROM in accordance with the invention is inserted into a slot for the present IC memory card that does not have the reproducing function for the hologram ROM, no information can be reproduced. Consequently, in the fourth and the fifth embodiments, in addition to the present reproducing apparatus for the IC card memory, the following is added: a two-dimensional light receiving element such as a CCD or CMOS (complementary metal oxide semiconductor) for reproducing the hologram ROM; a laser light source and a lens for inputting light into the waveguide; and a signal conversion circuit for converting into a data signal a light pattern focused on the two-dimensional light detecting element. Because of the addition, even in a case in which an optical memory medium having a hologram ROM, not an IC memory card, is inserted, information can be read out.

The first, second, fourth, and fifth embodiments in accordance with the invention explain a case in which the optical memory medium is constituted by combining the multi-layered waveguide hologram ROM and the IC memory. However, the invention is not limited to the embodiments. That is, the memory, which is used for reading and writing data, has only to be connected to the reproduction apparatus for the optical memory medium by electric terminals. Instead of the IC memory, various kinds of memories (for example, a flash memory, a HDD, or a MT) can be used that are explained as the memory 6-3 of the third embodiment in accordance with the invention. The use of these memories can also bring about the same effects.

In each of the embodiments, the recording medium is neither the IC memory itself nor the hologram ROM itself, but is a combination of the two. The entire size is, for example, 32 mm x 24 mm x 2.1 mm that is identical to an outer shape standard of the SD memory card. When the entire size is below 32 mm x 24 mm x 2.1 mm, the recording medium can be mounted to an adapter that is be inserted into the SD memory card slot, and then can be used.

According to the present invention, information a user wishes to update can be updated by using the memory, and at the same time contents can be reproduced from the hologram ROM (read only memory), with one card memory slot shared.

Where specifications for an outer shape of the optical memory medium and an interface of the memory can be made identical to the existing memory card (for example, an IC memory card), interchangeability between the optical memory medium and the existing memory card can be obtained.

Without changing the specification of an interface for the existing memory at all, it is possible to decide that the memory card inserted into the slot is one of the optical memory medium or the existing memory card.

INDUSTRIAL APPLICABILITY

According to the present invention, interchangeability between the hologram ROM storing contents and the memory such as a flash memory having the ability to rewrite data and mixed placement thereof allow a large capacity of contents to be obtained from the hologram ROM, and user information to be rewritten and stored by the memory.

The following can be obtained. A large capacity of data such as music can be stored on an inexpensive multi-layered waveguide hologram ROM, while license information regarding the data is stored in a RAM, which is available in the field of the music industry.

**Claims**

1. An optical memory medium comprising:

   at least one multi-layered waveguide hologram ROM for storing data to be read out by using diffracted light based on incident light to a multi-layered waveguide hologram to read out data; and
   at least one memory integrally constituted with the multi-layered waveguide hologram ROM for reading and writing data.

2. An optical memory medium as recited in claim 1, further comprising a guide for fixing the multi-layered waveguide hologram ROM so that the multi-layered waveguide hologram ROM is removable.

3. An optical memory medium as recited in claim 2, wherein the guide is provided with a groove having a predetermined width and length, and wherein at least one hologram ROM is fixed by the groove.

4. An optical memory medium as recited in claim 1, wherein the memory for reading and writing is an IC memory,
   and further comprising:

   a plurality of terminals for the IC memory placed in a predetermined circumferential portion of the optical memory medium; and
   an incident portion of reference light for the multi-layered waveguide hologram ROM placed in another circumferential portion adjacent to the predetermined circumferential portion for the terminals for the IC memory.

5. An optical memory medium as recited in claim 4, wherein the optical memory medium has external dimensions of 32 mm x 24 mm x 2.1 mm, or has all or any of the external dimensions less than 32 mm x 24 mm x 2.1 mm.

6. An optical memory medium as recited in claim 1, wherein the multi-layered waveguide hologram ROM and the memory are made in a shape of a plate, respectively, and are integrally stacked in the direction of a thickness thereof.

7. An optical memory medium as recited in claim 1, wherein the multi-layered waveguide hologram ROM and the memory are made in a shape of a plate, respectively, and are integrally arranged in the direction of a width or depth thereof.

8. An optical memory medium as recited in claim 1, further comprising a light absorbent on a surface tangent to a surface opposite to a surface from which the diffracted light of the multi-layered waveguide hologram ROM is taken out.

9. A reproduction apparatus for an optical memory medium comprising:

   an optical memory medium including:

      at least one multi-layered waveguide hologram ROM for storing data to be read out by using diffracted light based on incident light to a multi-layered waveguide hologram; and
      at least one memory integrally constituted with the multi-layered waveguide hologram ROM for reading and writing data;

   a light inputting unit for inputting light into the multi-layered waveguide hologram;
   a light receiving unit for receiving light diffracted at the multi-layered waveguide hologram based on the light input by the light inputting unit to convert into an electric signal; and
   a data record reproducing unit for reading and writing data with regard to the memory.

10. A reproduction apparatus for an optical memory medium as recited in claim 9, further comprising a determination unit for determining whether or not a medium being inserted is the optical memory medium, depending on whether or not the diffracted light emitted from the multi-layered waveguide hologram ROM is detected by the light receiving unit.

**11.** A determining method of determining a type of medium mounted in a reproduction apparatus for an optical memory medium by a determination unit provided with the reproduction apparatus for the optical memory medium that includes at least one multi-layered waveguide hologram ROM for storing data to be read out by using diffracted light based on incident light to a multi-layered waveguide hologram, and at least one memory integrally constituted with the multi-layered waveguide hologram ROM for reading and writing data, the method comprising:

> detecting that a medium is mounted;
> emitting light to a predetermined place of the mounted medium;
> monitoring whether or not diffracted light from the multi-layered waveguide hologram ROM is detected; and
> determining that the mounted medium is the optical memory medium when the diffracted light is detected.

**12.** A determining method as recited in claim 11, wherein the determining procedure determines that the mounted medium is an IC memory card when no diffracted light is detected.

**13.** A determining method as recited in claim 11, wherein the determination unit stops emitting the light when it is determined that the mounted medium is not the optical memory medium.

**14.** A determining method as recited in claim 11, wherein the monitoring procedure includes using a two-dimensional light receiving element for the detection of the diffracted light, and monitoring whether or not at least one area of the two-dimensional light receiving element has detected the diffracted light.

**15.** A determining method as recited in claim 11, wherein, when the hologram ROM can be removable with the optical memory medium mounted into the reproduction apparatus, after the detecting of the mounted medium, the procedure from the emitting of light to the determining of the mounted medium is repeated in a predetermined time interval.

FIG. 1

FIG. 2

## FIG. 3

## FIG. 4

## FIG. 5A

## FIG. 5B

## FIG. 6

FIG. 7

FIG. 8A

7-3  7-2  7-1

FIG. 8B

7-2  7-3  7-5

FIG. 8C

7-4  7-6

## INTERNATIONAL SEARCH REPORT

International application No.

PCT/JP2004/013999

### A. CLASSIFICATION OF SUBJECT MATTER
Int.Cl⁷ G06K19/00, G11B7/0065, G03H1/26

According to International Patent Classification (IPC) or to both national classification and IPC

### B. FIELDS SEARCHED

Minimum documentation searched (classification system followed by classification symbols)
Int.Cl⁷ G06K19/00, G03H1/26

Documentation searched other than minimum documentation to the extent that such documents are included in the fields searched

| | | | |
|---|---|---|---|
| Jitsuyo Shinan Koho | 1926-1996 | Jitsuyo Shinan Toroku Koho | 1996-2004 |
| Kokai Jitsuyo Shinan Koho | 1971-2004 | Toroku Jitsuyo Shinan Koho | 1994-2004 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y | JP 2003-141475 A (Nippon Telegraph And Telephone Corp.),<br>16 May, 2003 (16.05.03),<br>Par. Nos. [0016] to [0021]; Figs. 1 to 3<br>(Family: none) | 1,4,5-7,<br>9-15<br>2,3,8 |
| Y | JP 63-22617 U (Dainippon Printing Co., Ltd.),<br>15 February, 1988 (15.02.88),<br>Page 4, line 1 to page 13, line 4<br>(Family: none) | 2,3 |
| Y | JP 2001-265197 A (Dainippon Printing Co., Ltd.),<br>28 September, 2001 (28.09.01),<br>Par. No. [0008]<br>(Family: none) | 8 |

☐ Further documents are listed in the continuation of Box C.　　☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| | |
|---|---|
| Date of the actual completion of the international search<br>08 November, 2004 (08.11.04) | Date of mailing of the international search report<br>22 November, 2004 (22.11.04) |
| Name and mailing address of the ISA/<br>Japanese Patent Office | Authorized officer |
| Facsimile No. | Telephone No. |

Form PCT/ISA/210 (second sheet) (January 2004)